# EUROPÄISCHE PATENTANMELDUNG

(11) **EP 2 071 562 A2**
(43) Veröffentlichungstag der Anmeldung: **17.06.2009**
(21) Anmeldenummer: 08020885.3
(22) Anmeldetag: 02.12.2008
(51) Int. Cl.: G10K 11/175

(54) **Verfahren zur ansteuerung von zumindest einem geräuschemittierenden bauteil**

(30) Priorität: 11.12.2007 DE 102007059605
(71) Anmelder: Rohde & Schwarz GmbH & Co. KG, 81671 München (DE)
(72) Erfinder: Holzmann, Gottfried, 85604 Zorneding (DE); Freytag, Christian, 82008 Unterhaching (DE); Mahr, Roland, 83026 Rosenheim (DE)
(74) Vertreter: Beder, Jens

(57) **Zusammenfassung**

Das Verfahren betrifft die Ansteuerung zumindest eines geräuschemittierenden Bauteils (3, 5). Zunächst wird ein erster Einstellbereich für einen Steuerungsparameter für das geräuschemittierende Bauteil (3, 5) ermittelt, in dem das Bauteil (3, 5) seine technische Funktion erfüllt (S1). Das geräuschemittierende Bauteil wird mit einem Steuerungsparameter des ersten Einstellbereichs (I, I') angesteuert, wobei durch das Bauteil (3, 5) ein Geräusch mit einer ersten Grundfrequenz emittiert wird. Ein neuer, zweiter Einstellbereich (II, II') wird für den Steuerungsparameter ermittelt, wenn sich die durch das Bauteil (3, 5) zu erfüllende technische Funktion ändert (S3). Der eingestellte Ist-Steuerungsparameters wird mit dem neuen zweiten Einstellbereich (II, II', S4)verglichen und das Bauteil (3, 5) mit einem neuen Steuerungsparameter angesteuert, wenn der Ist-Steuerungsparameter außerhalb der Grenzen des neuen, zweiten Einstellbereichs liegt (S5), wobei der neue Steuerungsparameter so aus dem neuen, zweiten Einstellbereich ausgewählt wird, dass die neue, durch das geräuschemittierende Bauteil (3, 5)erzeugte zweite Grundfrequenz in einem musikalischen Sinn harmonisch zu der ersten Grundfrequenz ist. Bei mehreren geräuschemittierenden Bauteilen werden die einzelnen, emittierten Frequenzen musikalisch aufeinander abgestimmt.

## Beschreibung

Die Erfindung betrifft ein Verfahren zur Ansteuerung von zumindest einem geräuschemittierenden Bauteil.

In den meisten Vorrichtungen oder Anlagen sind Bauteile vorhanden, welche zur Erfüllung ihrer technischen Funktion durch zumindest einen Steuerungsparameter angesteuert werden. Beispielhaft kann hier ein Lüfter genannt werden. In Abhängigkeit von der erforderlichen Kühlleistung wird ein Lüftermotor mit einer bestimmten Eingangsspannung als Steuerungsparameter angesteuert. Die Größe des Steuerungsparameters, also hier die Höhe der Spannung, wird also durch die technische Funktion, im beschriebenen Beispiel der erforderliche Luftbedarf, bestimmt. Aber auch beim Antrieb beispielsweise von hydrostatischen Anlagen, wie sie in Kränen oder Baggern Verwendung finden, werden Bauteile, hier z. B. Antriebsmotoren, im Hinblick auf ihre zu erfüllende Funktion angesteuert und emittieren in Abhängigkeit von dieser Ansteuerung ein Geräusch, dem eine dominierende Frequenz und damit eine Tonhöhe zugeordnet werden kann.

In den meisten Fällen ist die zu erfüllende technische Funktion eine bestimmte Leistungsanforderung. So werden beispielsweise Antriebsmaschinen von Kränen drehzahlgeregelt. Im Betrieb kommt es durch die unterschiedlichen technischen Funktionen, die erfüllt werden müssen, zu unterschiedlichen Vorgaben der Steuerungsparameter. Die Änderung der Steuerungsparameter ist dabei in der Regel allein durch den Leistungsbedarf oder allgemeiner, die zu erfüllende technische Funktion bestimmt. Meist ist allerdings nicht nur eine geräuschemittierende Komponente vorhanden, sondern mehrere, welche individuell und jeweils aufgrund ihrer eigenen technischen Funktion angesteuert werden. Das emittierte Geräusch spielt bislang bei der Ansteuerung der Komponenten keine Rolle. Daher kommt es zu einer Geräuschemission, die keinerlei Systematik folgt, und die dementsprechend vom Menschen lediglich als Belästigung wahrgenommen wird.

Dies ist insbesondere beispielsweise auch bei der Verwendung von Lüftern der Fall, wie sie heutzutage selbst in einfachen Desktop-Computersystemen verbaut sind. Allein hier existieren in der Regel zumindest zwei Lüfter, die jeweils eine autarke Steuerung aufweisen. Diese autarke Steuerung ermittelt beispielsweise den Kühlluftbedarf für eine zentrale Recheneinheit des Computers und steuert somit den CPU-Lüfter aufgrund der CPU-Temperatur.

Hiervon unabhängig wird der in der Regel auf einer eingebauten Grafikkarte vorhandene weitere Lüfter allein auf Grund der in dem Grafikprozessor herrschenden Temperatur angesteuert. Es erfolgt zwischen den sich so ergebenden Lüfterdrehzahlen keinerlei Abgleich, weder hinsichtlich einer zeitlichen Koordination der Übergänge zwischen verschiedenen Drehzahlen als auch hinsichtlich der emittierten Frequenzen der Lüfter.

Es ist daher die Aufgabe der Erfindung, die subjektive Belästigung durch geräuschemittierende Bauteile zu verringern. Die Aufgabe wird durch das Verfahren gemäß Anspruch 1 gelöst.

Bei lediglich einem geräuschemittierenden Bauteil wird es in der Regel als unangenehm empfunden, dass das Verhältnis aufeinanderfolgender Frequenzen durch Änderung des Steuerungsparameters scheinbar willkürlich ist. Dies kommt durch die Regelung beispielsweise eines Elektromotors allein aufgrund des Leistungsbedarfs.

Um die zeitlich aufeinanderfolgenden Grundfrequenzen eines geräuschemittierenden Bauteils bei der Empfindung angenehmer zu gestalten, wird zunächst ein erster Einstellbereich für einen Steuerungsparameter für das geräuschemittierende Bauteil ermittelt. Innerhalb dieses ersten Einstellbereichs des Parameters kann das Bauteil seine technische Funktion erfüllen. Am Beispiel eines Lüfters bedeutet dies, dass in dem ermittelten Spannungsbereich, mit dem der Lüftermotor betrieben werden kann, der erzeugte Kühlluftstrom ausreichend groß ist, um die erforderliche Bauteilkühlung zu gewährleisten. In vergleichbarer Weise kann auch eine Drehzahl eines Antriebsmotors so gewählt werden, dass beispielsweise die Arbeitshydraulik eines Nutzfahrzeugs betrieben werden kann. Innerhalb dieses Einstellbereichs, der für die Erfüllung der technischen Funktion geeignet ist, kann zunächst der Steuerungsparameter beispielsweise nach energetischen Gesichtspunkten günstig ausgewählt werden. Mit dem so ausgewählten Steuerungsparameter wird das Bauteil angesteuert und erzeugt dadurch ein Geräusch mit einer ersten Grundfrequenz. Der Begriff "Geräusch" wird trotz des Auftretens einer zuordnenbaren Grundfrequenz anstelle von Ton verwendet, da ein als "Ton" empfundener Klang in der Regel nicht auftritt.

Ändert sich die zu erfüllende technische Funktion beispielsweise durch einen geänderten Kühlluftbedarf oder eine geänderte Leistungsanforderung, so wird hierfür ein neuer, zweiter Einstellbereich für den Steuerungsparameter ermittelt. Zur Erfüllung der technischen Funktion könnte nunmehr ein beliebiger Steuerungsparameter aus dem neuen Einstellbereich ausgewählt werden. Es wird der Ist-Steuerungsparameter mit dem neuen zweiten Einstellbereich verglichen und so ermittelt, ob überhaupt eine Änderung der Ansteuerung des geräuschemittierenden Bauteils erforderlich ist.

Liegt der Steuerungsparameter außerhalb der Grenzen des ermittelten neuen, zweiten Einstellbereichs, so wird ein neuer Steuerungsparameter zum Ansteuern des geräuschemittierenden Bauteils ausgewählt, welcher zum Einen innerhalb des neuen, zweiten Einstellbereichs liegt und der zum Anderen das geräuschemittierende Bauteil so ansteuert, dass die nunmehr erzeugte neue, zweite Grundfrequenz im musikalischen Sinne harmonisch zu der ersten Grundfrequenz ist. Solche im musikalischen Sinne harmonischen Grundfrequenzen liegen beispielsweise dann vor, wenn die zu unterschiedlichen Steuerungsparametern gehörenden, aufeinanderfolgend emittierten Grundfrequenzen einem Dur- oder Moll-Dreiklang entnommen sind, dessen Grundton beispielsweise durch die erste erzeugte Grundfrequenz definiert ist. So können beispielsweise die Steuerungsparameter für nacheinander steigende Leistungsanforderungen eines Kühlgebläses so gewählt sein, dass nacheinander die Tonstufen c, e und f erzeugt werden. Dies entspricht einem C-Dur-Dreiklang.

Eine Limitierung auf den lediglich beispielhaft vorgeschlagenen C-Dur-Dreiklang existiert dabei selbstverständlich nicht. Die aufeinanderfolgenden Grundfrequenzen bzw. die entsprechend auszuwählenden Steuerparameter können dabei jeweils so gewählt werden, dass die Grundregeln einer frei wählbaren Harmonielehre erfüllt werden. Um eine höhere Flexibilität in den auszuwählenden Frequenzstufen zu erhalten, sind so im einfachsten Fall die Dreiklänge einer Kadenz zu verwenden. Die Kadenz einer Tonart enthält mit Tonika, Dominante und Subdominante alle leitereigenen Töne einer bestimmten Tonart.

Werden die Grundregeln der Harmonielehre beachtet und die Steuerungsparameter für ein geräuschemittierendes Bauteil entsprechend ausgewählt, so wird das erzeugte Geräusch durch das geräuschemittierende Bauteil, obwohl es gleichzeitig die jeweils technischen Funktionen übernehmen kann, als weniger störend empfunden.

Dabei ist insbesondere zu beachten, dass jedes geräuschemittierendes Bauteil, dessen Grundfrequenz wesentlich von dem ansteuernden Steuerungsparameter abhängt, in der beschriebenen Weise angesteuert werden kann. Bei der Ansteuerung von asynchronen Motoren, wie sie beispielsweise in S-Bahnen eingesetzt werden, könnte auf diese Weise das durch die Phasenumrichter erzeugte Geräusch beeinflusst werden.

Für zeitlich konstante Ansteuerungen mehrerer Bauteile werden die Steuerungsparameter so gewählt, dass sie in jeweils einem für ein Bauteil ermittelten Einstellbereich liegen und die Bauteile dabei musikalisch harmonische Frequenzen erzeugen.

In den Unteransprüchen sind vorteilhafte Weiterbildungen ausgeführt.

Insbesondere ist es bevorzugt, dass bei mehreren geräuschemittierenden Bauteilen für jedes Bauteil jeweils ein Einstellbereich für den jeweiligen Steuerungsparameter ermittelt wird. In diesem ermittelten Einstellbereich erfüllt das Bauteil seine technische Funktion und es wird für jedes Bauteil jeweils ein Steuerungsparameter aus dem zugeordneten Einstellbereich so ausgewählt, dass die von den einzelnen Bauteilen daraufhin erzeugten Geräusche Grundfrequenzen aufweisen, die im musikalischen Sinn harmonisch zueinander sind. Damit können beispielsweise durch drei geräuscherzeugende Bauteile Grundfrequenzen im Sinne eines Dreiklangs erzeugt werden. Solchermaßen an die Harmonielehre angepasste Grundfrequenzen der Bauteile werden durch beispielsweise einen Nutzer einer Teststation mit mehreren Lüftern als weniger störend empfunden. Erweiterungen auf eine höhere Anzahl geräuschemittierender Bauteile oder die Reduzierung auf zwei ist selbstverständlich möglich.

Weiterhin ist es vorteilhaft, den Steuerungsparameter für ein ausgewähltes Bauteil allein aufgrund einer technischen Funktion aus dem Einstellbereich auszuwählen. Für die weiteren Bauteile wird die Auswahl der Steuerungsparameter innerhalb des jeweiligen Einstellbereichs unter Berücksichtigung der musikalischen Harmonielehre in Abhängigkeit von dem ausgezeichneten ersten Bauteil gewählt. Damit wird der Harmonielehre insofern Rechnung getragen, dass jeweils durch eine Frequenz des ausgewählten Bauteils der Ausgangspunkt zum Bilden einer Harmonie festgelegt wird. Da lediglich die relativen Tonhöhen zueinander von Bedeutung sind, kann der "Grundton" besonders flexibel festgelegt werden. Damit können auch kleinere Frequenzschritte durch den Grundton vorgegeben werden, wobei die anderen Bauteile hieran angepasst betrieben werden. Die absolute Tonhöhe ist für den Mehrklang und für das autark betriebene Bauteil ohne Belang. Dies vereinfacht die Steuerung.

Weiterhin ist es vorteilhaft, wenn die geräuschemittierenden Bauteile Motoren sind, eine Drehzahlregelung für die Motoren vorzunehmen. Mit Hilfe einer solchen Drehzahlregelung kann in einfacher Weise mit dem Drehzahlverhältnis das erwünschte Frequenzverhältnis vorgegeben werden.

Gemäß einer anderen vorteilhaften Ausführungsform wird die von den einzelnen geräuschemittierenden Bauteilen erzeugte Geräuschemission akustisch, z. B. durch ein Mikrofon, erfasst und insbesondere wird eine Frequenzanalyse des erfassten Geräuschs durchgeführt. Auf Basis dieser Frequenzanalyse werden dann die Steuerungsparameter für die einzelnen Bauteile bestimmt. Dies betrifft insbesondere auch eine Korrektur, sofern zwei Bauteile die gleiche Grundfrequenz erzeugen sollen. Mit Hilfe der Frequenzanalyse können geringfügige Frequenzunterschiede exakt analysiert werden und durch eine entsprechende Anpassung des Steuerungsparameters, der die Bauteile ansteuert, kann das Entstehen einer Schwebung verhindert werden. Schwebungen werden als besonders störend empfunden.

Weiterhin ist es vorteilhaft, dass bei einer Änderung der technischen Anforderung, z.B. einer geänderten Leistungsanforderung oder eines Luftstroms bei einer Gebläsekühlung; jeweils ein neuer Einstellbereich für den Steuerungsparameter dieses geräuschemittierenden Bauteils ermittelt wird. Der neue Einstellbereich trägt dabei der neuen technischen Anforderung Rechnung und definiert ein Intervall, innerhalb dessen der Steuerungsparameter frei ausgewählt werden kann, sodass das entsprechende Bauteil die technische Funktion erfüllt. Der Steuerungsparameter für das Bauteil wird so aus dem neuen Einstellbereich ausgewählt und das Bauteil damit angesteuert, dass das Bauteil ein Geräusch mit einer neuen Grundfrequenz emittiert, die zu den Grundfrequenzen der weiterhin unverändert angesteuerten Bauteile in einem musikalischen Sinne harmonisch ist.

Dabei wird bei der Ansteuerung eines Bauteils mit einem neuen Steuerungsparameter vorzugsweise ein minimaler Abstand des Steuerungsparameters von den Grenzen des neuen Einstellbereichs eingehalten. Durch einen solchen minimalen Abstand von den Grenzen des Einstellbereichs wird sichergestellt, dass zumindest für eine bestimmte Zeitspanne der eingestellte Steuerungsparameter beibehalten werden kann, ohne außerhalb des weiterhin an die aktualisierten Anforderungen angepassten Einstellbereichs zu geraten. Zudem ist es vorteilhaft, die Änderung von Steuerungsparametern nur zu einem durch einen Takt vorgegebenen Zeitpunkt stattfinden zu lassen. Das zeitlich unsystematische Ändern jeweils einzelner Steuerungsparameter der Bauteile kann somit verhindert werden. So wird zum Beispiel anstelle von zwei kurz aufeinanderfolgenden Änderungen von Steuerungsparametern zweier Bauteile zum gleichen Zeitpunkt die Änderung des Steuerparameters für jedes Bauteil durchgeführt. Damit kann unter anderem auch die Änderung eines Dreiklangs realisiert werden.

Besonders bevorzugt ist es, wenn verschiedenen Sätze von musikalischen Harmonien in einer Tabelle in Form von Steuerungsparametern gespeichert sind. Die Anzahl der musikalischen Harmonien kann dabei zum Beispiel auch den einzelnen Stufen, in denen eine Regelung erfolgen soll, Rechnung tragen. Mittels einer solchen Tabelle ist es besonders einfach, bei einer geänderten Anforderung an lediglich ein Bauteil aus der Tabelle einen neuen Steuerungsparameter auszuwählen.

Vorzugsweise werden die Grundfrequenzen unterschiedlicher geräuschemittierender Bauteile unterschiedlich gewählt. Damit kann das Auftreten von sog. Schwebungen vollständig eliminiert werden.

Ein bevorzugtes Ausführungsbeispiel des erfindungsgemäßen Verfahrens ist in der Zeichnung dargestellt und wird anhand der nachfolgenden Beschreibung näher erläutert. Es zeigen:
- Figur 1: Ein erstes Beispiel für zwei geräuschemittierende Bauteile, die drehzahlgeregelt sind;
- Figur 2: ein zweites Ausführungsbeispiel, bei dem die drehzahlgeregelten Bauteile unter Verwendung einer akustischen Messung angesteuert werden;
- Figur 3: ein Beispiel für den zeitlichen Verlauf eines Steuerungsparameters eines einzelnen geräuschemittierenden Bauteils;
- Figur 4: ein Beispiel für die Festlegung eines minimalen Abstands des gewählten Steuerungsparameters von der Grenze des möglichen Einstellbereichs; und
- Figur 5: ein stark vereinfachtes Ablaufdiagramm des erfindungsgemäßen Verfahrens.

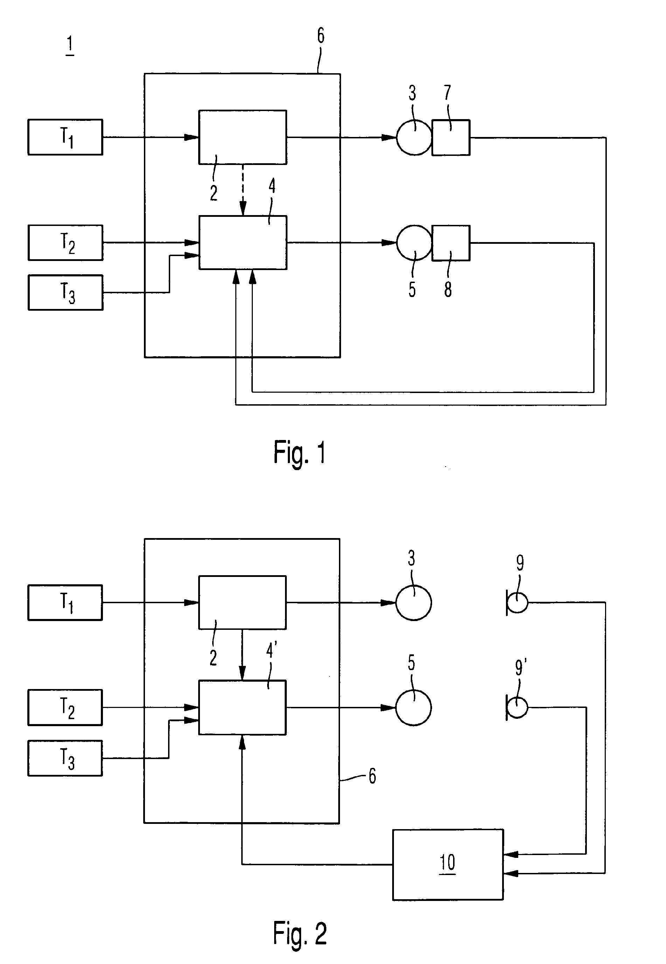

In der Figur 1 ist stark vereinfacht ein Blockschaltbild zur Durchführung des erfindungsgemäßen Verfahrens dargestellt. Das Blockschaltbild 1 zeigt ein erstes Steuergerät 2 und ein zweites Steuergerät 4. Das erste Steuergerät 2 ist zur Ansteuerung eines ersten Lüftermotors 3 vorgesehen. Dementsprechend ist das zweite Steuergerät zur Ansteuerung eines zweiten Lüftermotors 5 vorgesehen. Die beiden Lüftermotoren 3, 5 können beispielsweise zwei Lüfter eines Messaufbaus antreiben. So kann der erste Lüfter mit dem ersten Lüftermotor 3 eine zentrale Recheneinheit auf einer Hauptplatine kühlen. Der zweite Lüfter mit dem zweiten Lüftermotor 5 ist dagegen zum Beispiel zur Kühlung eines Prozessors auf einer Einsteckkarte des Messgeräts vorgesehen. Üblicherweise werden im Stand der Technik die beiden Lüfter individuell durch ihre jeweils zugeordnete elektronische Steuereinrichtung angesteuert. Dazu wird zum Erreichen einer bestimmten Lüfterdrehzahl eine Spannung durch die elektronische Steuereinheit vorgegeben. Diese Spannung wird durch die elektronische Steuereinheit auf Basis eines Temperatursignals festgelegt, dass durch einen ersten Temperatursensor T₁ ermittelt wird. Die Verwendung nur eines Temperatursensors T₁ ist selbstverständlich nur beispielhaft. Es können auch mehrere Temperatursensoren vorgesehen sein.

Bei dem erfindungsgemäßen Verfahren wird bevorzugt ein ausgewählter Lüfter, im dargestellten Ausführungsbeispiel der erste Lüftermotor 3, allein in Abhängigkeit von der ermittelten Temperatur des ersten Temperatursensors T₁ betrieben. Der erste Temperatursensor T₁ misst beispielsweise die Temperatur der zentralen Recheneinheit der Platine und übermittelt ein entsprechendes Signal an die erste Steuereinheit 2. Die erste Steuereinheit 2 ermittelt eine notwendige Lüfterdrehzahl und eine dazu passende Steuerspannung, um einen ausreichenden Kühlluftstrom zu erzeugen. Diese Spannung wird an den Lüftermotor 3 weitergeleitet, der ein von der Drehzahl abhängiges Geräusch erzeugt, welches eine erste Grundfrequenz aufweist.

Erfindungsgemäß wird nun die Drehzahl des zweiten Lüftermotors 5 so gesteuert, dass sie in einem musikalisch harmonischen Sinne zu der Drehzahl des ersten Lüftermotors 3 passt. Hierzu wird dem zweiten Steuergerät 4 eine Information über die Drehzahl bzw. Grundfrequenz des ersten Lüftermotors 3 übermittelt. Im dargestellten Ausführungsbeispiel werden die Drehzahlen des ersten Lüftermotors 3 und des zweiten Lüftermotors 5 jeweils durch einen Drehzahlmesser 7, 8 ermittelt und entsprechende Drehzahlsignale an das zweite Steuergerät 4 übermittelt. Darüber hinaus wird dem zweiten Steuergerät 4 beispielsweise ein Signal über weitere Temperaturen durch weitere Temperatursensoren T₂, T₃ zugeführt. Auf Basis dieser beiden gemessenen Temperaturen wird zunächst der überhaupt mögliche Einstellbereich für den Steuerungsparameter für den zweiten Lüftermotor 5 ermittelt. Dieser Einstellbereich gibt diejenigen Spannungen vor, mit denen der zweite Lüftermotor 5 angesteuert werden kann, sodass der resultierende Kühlluftstrom ausreichend ist, um die technische Anforderung an den Lüfter zu erfüllen. Innerhalb des so ermittelten Einstellbereichs wird dann durch das zweite Steuergerät 4 ein Steuerungsparameter für den zweiten Lüftermotor 5, im Beispiel des zweiten Lüftermotors 5 also eine Spannung, ermittelt, bei der die Drehzahl des zweiten Lüftermotors 5 in einem musikalischen Verhältnis zu der Drehzahl des ersten Lüftermotors 3 steht. Im dargestellten Ausführungsbeispiel erhält das zweite Steuergerät 4 die notwendigen Informationen durch die Drehzahlmesser 7, 8. Ohne eine solche Drehzahlmessung sind vorzugsweise die Steuergeräte 7, 8 so miteinander verbunden, dass eine der Drehzahl entsprechende Information von dem ersten Steuergerät 2 an das zweite Steuergerät 4 übertragen wird. Dies ist in der Figur 1 durch den gestrichelten Pfeil dargestellt.

Die Steuergeräte 2, 4 sind im dargestellten Ausführungsbeispiel Teile einer Gerätesteuerung 6. Die Erfindung ist aber auch bei verteilten Systemen anwendbar, bei denen die geräuschemittierenden Bauteile auf mehrere Geräte verteilt sind.

Mit Hilfe des Korrektursignals kann sichergestellt werden, dass das tatsächliche Verhältnis der Grundfrequenzen harmonisch ist. Insbesondere wenn identische Grundfrequenzen emittiert werden ist dies wichtig, um Schwankungen zu vermeiden. Durch die Messung der tatsächlichen Drehzahlen oder auch der tatsächlich emittierten Grundfrequenzen können auch lastabhängige Abweichungen vom Sollwert korrigiert werden.

In der Figur 2 ist ein leicht abgewandeltes Ausführungsbeispiel dargestellt. Anstelle der Drehzahlerfassung des ersten Lüftermotors 3 und des zweiten Lüftermotors 5 werden hier zwei Mikrofone 9, 9' eingesetzt, welche das jeweils durch den Lüftermotor 3 bzw. 5 emittierte Geräusch aufnehmen. Mit Hilfe einer Frequenzanalyse werden die einzelnen Frequenzen und so auch die Grundfrequenzen des ersten Lüftermotors 3 und des zweiten Lüftermotors 5 ermittelt. Um die Drehzahl des zweiten Lüftermotors 5 in einem musikalischen Sinne harmonisch zu der Drehzahl des ersten Lüftermotors 3 zu gestalten, wird durch eine Frequenzanalysevorrichtung 10 ein Korrektursignal ermittelt. Das Korrektursignal wird der zweiten Steuereinrichtung 4' zugeführt. Wie schon beim Ausführungsbeispiel der Fig. 1 ist dabei die Drehzahlregelung für den ausgewählten ersten Lüftermotor 3 ausschließlich durch die ermittelte Temperatur des ersten Temperatursensors T₁ bestimmt.

Im dargestellten Ausführungsbeispiel ist die Vernetzung der Lüftermotoren bzw. der Steuergeräte 2, 4 besonders einfach, da die Motoren zu demselben Gerät gehören. Es ist jedoch auch denkbar, dass die angesteuerten Lüftermotoren 3, 5 oder andere geräuschemittierende Bauteile zu verschiedenen Geräten gehören. Um auch in diesem Fall eine Ansteuerung zu ermöglichen, die Grundfrequenzen erzeugt, welche im musikalischen Sinne harmonisch zueinander sind, ist insbesondere das Ausführungsbeispiel der Fig. 2 geeignet. Hier kann zum Beispiel jedes zusätzlich zu einem ersten Gerät vorhandene weitere Gerät mit einem geräuscherzeugenden Bauteil über ein zweites Steuergerät 4' verfügen, welches das durch die Frequenzanalysevorrichtung 10 erzeugte Korrektursignal verarbeiten kann. Da es lediglich auf die relative Tonhöhe der erzeugten Grundfrequenzen ankommt, nicht aber auf die absolute Tonhöhe, kann somit der erste Lüftermotor 3 ohne technischen Eingriff betrieben werden und gibt damit seine Grundfrequenz als Basis für die musikalisch harmonische Ansteuerung der weiteren geräuscherzeugenden Bauteile vor.

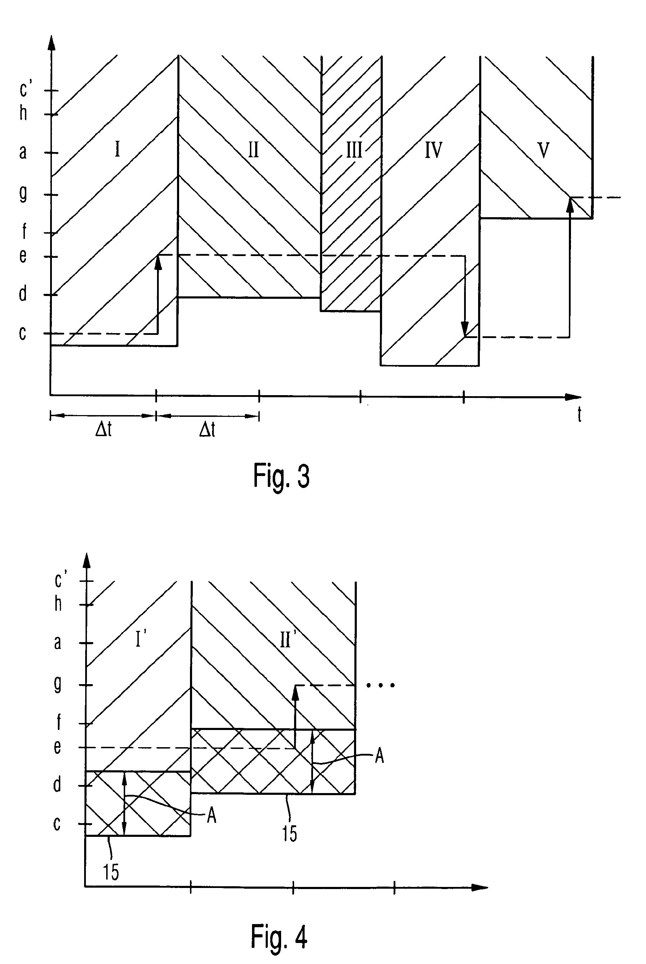

In der Fig. 3 ist beispielhaft der Verlauf eines Steuerungsparameters angegeben. Während des Betriebs eines Geräts mit einem Lüfter ändert sich der Kühlluftbedarf beispielsweise so, dass das Einstellen eines Steuerungsparameters, innerhalb der schraffierten Bereiche I-IV zu einem ausreichend großen Kühlluftstrom führen würde. Demnach kann innerhalb des jeweils schraffierten Bereichs die Ansteuerung des ersten Lüftermotors 3 erfolgen, wobei eine ausreichende Kühlung gewährleistet ist.

Im dargestellten Ausführungsbeispiel wird zunächst der erste Lüftermotor 3 mit einer Spannung angesteuert, sodass die Grundfrequenz aufgrund der erzeugten Lüfterdrehzahl der Tonhöhe c entspricht. Die Tonhöhen, die den erzeugten Grundfrequenzen entsprechen, sind auf der Ordinate aufgetragen. Da bei gerade noch ausreichender Kühlung damit zu rechnen ist, dass eine Erhöhung der Lüfterdrehzahl erforderlich sein könnte, wird nach einer Zeitdauer Δt, die einen Takt zur Aktualisierung des Steuerungsparameters vorgibt, die Lüfterdrehzahl angehoben, obwohl der dem Ton c entsprechende Steuerungsparameter noch ausreichend wäre. In dem dargestellten Ausführungsbeispiel wird dabei der Steuerungsparameter zur Ansteuerung des ersten Lüftermotors 3 so angehoben, dass die Note e der Grundfrequenz aufgrund der Drehzahl des ersten Lüftermotors 3 entspricht. Eine Änderung des Steuerungsparameters ist dabei jeweils innerhalb der schraffierten Bereiche, die den möglichen Einstellbereichen entsprechen, möglich. Im Folgenden wird die Tonhöhe e beibehalten, der Steuerungsparameter für den ersten Lüftermotor also nicht geändert. Erst in dem Bereich IV, in dem eine deutlich geringere Kühlleistung ausreichend ist, wird der Steuerungsparameter neuerlich so geändert, dass wiederum eine Grundfrequenz, die dem Ton c entspricht, erzeugt wird. In dem letzten Bereich V ist es gezeigt, dass bei plötzlich stark steigendem Kühlluftbedarf die Tonhöhe c nicht mehr ausreichend ist, um für ausreichende Kühlung zu sorgen. In dem dargestellten Beispiel, bei dem die Taktlänge durch die Zeitfenster Δt relativ lang gewählt ist, wird daher bis zum Sprung auf die Tonhöhe g eine Erwärmung des zu kühlenden Bauteils auftreten. Überhitzungen werden vermieden, indem die Taktlänge Δt entsprechend kurz gewählt wird.

Um die Wahrscheinlichkeit, dass ein solcher Fall auftritt, zu verringern, kann vorgesehen sein, dass ausgehend von einer Intervallgrenze 15 ein minimaler Abstand A vorgegeben ist, der bei Einstellen eines neuen Steuerungsparameters ungenutzt bleibt. Wird dann, wie es in der Fig. 4 beispielhaft dargestellt ist, ein geänderter Einstellbereich II' ermittelt, so liegt dennoch die Tonhöhe e mit der der erste Lüftermotor 3 betrieben wird, innerhalb der Grenzen des neuen, zweiten Einstellbereichs. Nach Ablauf der zweiten Zeitperiode Δt wird dann wiederum ein Steuerungsparameter aus dem neuen, zweiten Einstellbereich II' ausgewählt, der außerhalb des Abstands A von der neuen Intervallgrenze 15' liegt. Sämtliche Einstellbereiche I-V und I', II' sind im Falle von Gebläselüftern bzw. erstem und zweiten Lüftermotor 3, 5 nach oben offen, da selbstverständlich eine höhere Kühlung weiterhin die technische Funktion des Lüfters sicherstellt. Bei anderen geräuschemittierenden Bauteilen kann jedoch auch eine Obergrenze für den Einstellbereich auftreten. Auch dort wird dann vorzugsweise ein gesperrter Bereich vorgesehen, in dem der Steuerungsparameter bei Änderung nicht gelegt wird.

Die in den Fig. 3 und 4 dargestellte Vorgehensweise zur Auswahl aufeinanderfolgender Steuerungsparameter bzw. der Einstellung der entsprechenden Grundfrequenzen des angesteuerten geräuschemittierenden Bauteils gilt in gleicher Weise auch für jedes weitere geräuschemittierende Bauteil. Dabei wird allerdings zusätzlich zu dem zeitlichen Verlauf berücksichtigt, dass die gleichzeitig durch die angesteuerten Bauteile emittierten Grundfrequenzen in einem harmonischen Verhältnis zueinander stehen müssen. Um lediglich die Steuerungsparameter einzelner Bauteile zu verändern, während bei anderen zum Beispiel der Kühlluftbedarf konstant bleibt, kann auch in vorteilhafter Weise mit Umkehrungen von Mehrklängen gearbeitet werden. Auf diese Weise können bei einem C-Dur-Dreiklang zum Beispiel die Tonhöhen e und g beibehalten werden, während anstelle des tiefen c's für den Grundton das gestrichene c' ausgewählt und ein entsprechender Steuerungsparameter aus dem ermittelten Einstellbereich ermittelt wird. Ist eine zeitliche Änderung nicht erforderlich, so werden die Steuerungsparameter von mehreren Bauteilen lediglich einmalig festgelegt.

Die dargestellten Ausführungsbeispiele beziehen sich jeweils lediglich auf die C-Dur Tonleiter. Eine entsprechende Erweiterung auf andere tonale Systeme oder unterschiedliche Harmoniebildungen ist jedoch ebenso möglich. Besonders einfach funktioniert die Regelung, wenn es sich bei den geräuschemittierenden Bauteilen um Motoren handelt. Diese können dann drehzahlgeregelt werden. Der Einfachheit halber wird die Grundfrequenz dabei als proportional zu der Drehzahl des angesteuerten Motors angesehen. Vorzugsweise ist zusätzlich zu den elektronischen Steuergeräten 2, 4 und 4' der Fig. 2 und 3 eine übergeordnete elektronische Steuereinheit vorhanden, welche die einzelnen Steuerungsparameter koordiniert. Hierzu werden die Steuergeräte 2, 4, 4' mit der übergeordneten Steuereinheit verbunden und übermitteln jeweils den möglichen Einstellbereich zum Erfüllen der technischen Funktion der angesteuerten Bauteile. In dem übergeordneten Steuergerät wird dann aus einer Tabelle ein Satz Frequenzen bzw. Töne ausgewählt und den daran angeschlossenen Steuergeräten 2, 4, 4' übermittelt. Die Steuergeräte 2, 4, 4' übermitteln vorzugsweise den möglichen Einstellbereich bereits in Form von Tonhöhen an das übergeordnete Steuergerät. Das übergeordnete Steuergerät ist damit systemunabhängig und die letztlich ausgewählten Steuerungsparameter können durch das jeweilige Steuergerät 2, 4, 4' des geräuschemittierenden Bauteils ermittelt werden. Die übergeordnete Steuereinheit gibt lediglich die harmonisch ausgewählten Tonhöhen vor und übermittelt eine Tonhöhe an je ein Steuergerät.

Die Frequenzverhältnisse folgen dabei vorzugsweise der sog. temperierten Stimmung, wie sie den Mehrklängen der klassischen Harmonielehre zugrunde liegt. Neben den Umkehrungen für die Mehrklänge kann beispielsweise auch der Wechsel der Tonart von Dur nach Moll oder umgekehrt eingesetzt werden, um die einzelnen Frequenzsprünge bedarfsgerecht klein zu halten.

Wird auf eine Rückführung der tatsächlichen Drehzahl, sei es durch Drehzahlsensoren 7, 8 oder aber eine akustische Analyse mittels Mikrofonen 9, 9' verzichtet, so wird bevorzugt ein bekannter Zusammenhang zwischen dem Ansteuersignal und der Drehzahl und damit der emittierten Grundfrequenz verwendet. Problematisch dabei ist allerdings die Lastabhängigkeit. Da damit die tatsächliche Drehzahl von der beabsichtigten Drehzahl abweichen kann, ist es bevorzugt, unterschiedliche Grundfrequenzen bei unterschiedlichen Bauteilen zu verwenden, um Schwebungen zu vermeiden.

Eine nicht vollständige Tabelle für mögliche Mehrklänge einschließlich der zugehörigen Grundfrequenzen bei temperierter Stimmung für die Tonart C-Dur ist nachfolgend gezeigt.

| | | | |
|---|---|---|---|
| C-Dur | c (261,63Hz) | e (329,63Hz) | g (392Hz) |
| d-moll | d (293,66Hz) | f (349,23Hz) | a (440Hz) |
| e-moll | e (329,63Hz) | g (392Hz) | h (493,88) |
| F-Dur | f (349,23Hz) | a (440Hz) | c' (523,25Hz) |
| G-Dur | g (392Hz) | h (493,88Hz) | d' (587,33Hz) |
| a-moll | a (440Hz) | c' (523,25Hz) | e' (659,26Hz) |
| h (vermindert) | h (493,88Hz) | d' (587,33Hz) | f' (698,46Hz) |

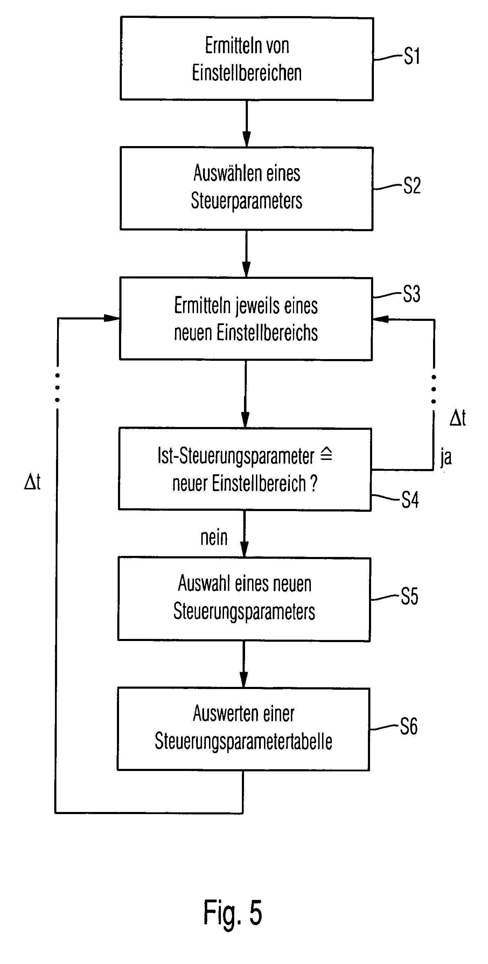

Ein vereinfachtes Schema zum Ablauf des Verfahrens ist in der Fig. 5 dargestellt. Zunächst wird für jedes Bauteil ein möglicher Einstellbereich ermittelt, bei dem das angesteuerte Bauteil seine Funktion erfüllen kann (S1). Aus diesem Einstellbereich wird für ein ausgezeichnetes Bauteil zunächst ein Steuerungsparameter ausgewählt (S2). Dieses ausgewählte Bauteil kann weiterhin autark betrieben werden, da im Weiteren die Drehzahlen der übrigen Lüftermotoren relativ zu dem ausgewählten Lüftermotor eingestellt werden. Handelt es sich nur um einen Lüfter, so wird nach jeweils einer bestimmten Zeitperiode ein neuer Einstellbereich ermittelt (S3), welcher den geänderten Anforderungen an die Funktion Rechnung trägt. Anschließend wird der aktuell eingestellte Steuerparameter (Ist-Steuerungsparameter) mit dem neuen Einstellbereich verglichen (S4). Liegt der Ist-Steuerungsparameter noch innerhalb des neuen Einstellbereichs, so wird wiederum nach einer vorgegebenen Zeitspanne Δt jeweils der neue Einstellbereich ermittelt. Liegt dagegen der Ist-Steuerungsparameter außerhalb des neuen Einstellbereichs, so wird ein neuer Steuerungsparameter nach den zuvor beschriebenen Regeln zur Auswahl ermittelt (S5). Bei lediglich einem angesteuerten Bauteil muss der neue Steuerungsparameter so gewählt werden, dass die entsprechende neue Grundfrequenz sich musikalisch harmonisch zu der vorangegangenen Grundfrequenz verhält.

Hierzu wird eine Steuerungsparameterauswertetabelle, die z.B. der oben angegebenen C-Dur Tabelle entsprechen kann, in der die möglichen Frequenzsprünge oder die jeweils zuzuordnenden Steuerungsparameter enthalten sind, verwendet (S6). Nach Einstellen des neuen Steuerungsparameters wird dann wiederum nach einem Zeitintervall Δt ein neuer Einstellbereich ermittelt. Diese Regelschleife wird solange durchlaufen, wie das Gerät aktiv ist und eine Regelung der Steuerungsparameter für die geräuschemittierenden Bauteile erfolgen muss.

Das vereinfachte Diagramm zum Ablauf des Verfahrens ist für lediglich ein geräuschemittierendes Bauteil dargestellt. Es ist jedoch leicht ersichtlich, dass dies parallel auch für mehrere geräuschemittierende Bauteile durchgeführt werden kann. Dabei wird das Verfahren lediglich dahingehend ergänzt, dass zusätzlich zu der jeweils vorangegangenen Tonhöhe auch die aktuellen Tonhöhen der übrigen geräuschemittierenden Bauteile verwendet werden und bei der Auswahl eines neuen Steuerparameters aus der Steuerparametertabelle berücksichtigt werden.

Die Erfindung ist nicht auf das dargestellte Ausführungsbeispiel beschränkt. Vielmehr sind auch Kombinationen einzelner Merkmale miteinander in vorteilhafter Weise möglich.

## Patentansprüche

1. Verfahren zur Ansteuerung zumindest eines geräuschemittierenden Bauteils (3, 5) mit folgenden Verfahrensschritten:
- Ermitteln eines ersten Einstellbereichs für einen Steuerungsparameter für das geräuschemittierende Bauteil (3, 5), in dem das Bauteil (3, 5) seine technische Funktion erfüllt (S1),
- Ansteuern des geräuschemittierenden Bauteils mit einem Steuerungsparameter des ersten Einstellbereichs (I, I'), wobei durch das Bauteil (3, 5) ein Geräusch mit einer ersten Grundfrequenz emittiert wird,
- Ermitteln eines neuen zweiten Einstellbereichs (II, II') für den Steuerungsparameter, wenn sich die durch das Bauteil (3, 5) zu erfüllende technische Funktion ändert (S3),
- Vergleichen des eingestellten Ist-Steuerungsparameters mit dem neuen zweiten Einstellbereich (II, II', S4),
- Ansteuern des Bauteils (3, 5) mit einem neuen Steuerungsparameter, wenn der Ist-Steuerungsparameter außerhalb der Grenzen des neuen, zweiten Einstellbereichs liegt (S5), wobei der neue Steuerungsparameter so aus dem neuen, zweiten Einstellbereich ausgewählt wird, dass die neue, durch das geräuschemittierende Bauteil (3, 5)erzeugte zweite Grundfrequenz in einem musikalischen Sinn harmonisch zu der ersten Grundfrequenz ist.

2. Verfahren nach Anspruch 1,
**dadurch gekennzeichnet,**
**dass** bei mehreren geräuschemittierenden Bauteilen (3, 5) für jedes Bauteil (3, 5) ein Einstellbereich für den jeweiligen Steuerungsparameter ermittelt wird (S1), in dem das Bauteil (3, 5) seine technische Funktion erfüllt, und für jedes Bauteil (3, 5) der Steuerungsparameter aus dem Einstellbereich (I, I') so ausgewählt wird, dass die von den Bauteilen gleichzeitig erzeugten Geräusche Grundfrequenzen aufweisen, die im musikalischen Sinn harmonisch zueinander sind.

3. Verfahren nach Anspruch 2,
**dadurch gekennzeichnet,**
**dass** der erste und der zweite Steuerungsparameter für ein ausgewähltes Bauteil (3) allein aufgrund der technischen Funktion aus dem ersten oder zweiten Einstellbereich ausgewählt werden und für die weiteren Bauteile (5) eine Auswahl der jeweiligen Steuerungsparameter innerhalb des jeweiligen Einstellbereichs unter Berücksichtigung der musikalischen Harmonielehre erfolgt.

4. Verfahren zur Ansteuerung von mehreren geräuschemittierenden Bauteilen (3, 5) mit folgenden Verfahrensschritten:
- Ermitteln jeweils eines Einstellbereichs für jedes der geräuschemittierenden Bauteile (3,5),
- Auswählen jeweils eines Steuerungsparameters aus dem Einstellbereich, so dass die mit den Steuerungsparametern angesteuerten Bauteile (3, 5) Geräusche emittieren, deren Grundfrequenzen in einem musikalischen Sinn harmonisch zueinander sind.

5. Verfahren nach einem der Ansprüche 1 bis 4,
**dadurch gekennzeichnet,**
**dass** die geräuschemittierenden Bauteile (3, 5) Motoren sind und die Motoren (3, 5) drehzahlgeregelt werden.

6. Verfahren nach einem der Ansprüche 1 bis 5,
**dadurch gekennzeichnet,**
**dass** die von den einzelnen geräuschemittierenden Bauteilen (3, 5) erzeugte Geräuschemission mittels zumindest eines Mikrofons (9, 9') erfasst werden.

7. Verfahren nach Anspruch 5,
**dadurch gekennzeichnet,**
**dass** auf Basis der akustisch durch ein Mikrofon erfassten Geräuschemission eine Frequenzanalyse durchgeführt wird und der Steuerungsparameter des jeweiligen Bauteils (3, 5) unter Berücksichtigung der Frequenzanalyse aus dem Einstellbereich (I, I', II, II',... V) ausgewählt wird.

8. Verfahren nach Anspruch 5,
**dadurch gekennzeichnet,**
**dass** die Drehzahlen der Motoren (3, 5) ermittelt werden und die Auswahl der Steuerungsparameter auf Basis der Drehzahlen als Grundfrequenz erfolgt.

9. Verfahren nach einem der Ansprüche 1 bis 8,
**dadurch gekennzeichnet,**
**dass** bei einer Änderung der technischen Anforderung an eines der geräuschemittierenden Bauteile jeweils ein neuer Einstellbereich (II, II', III, IV, V) für den Steuerungsparameter ermittelt wird, in dem die geänderte technische Anforderung durch das geräuschemittierende Bauteil (3, 5) erfüllt wird, und das geräuschemittierende Bauteil (3, 5) so mit einem aus dem neuen Einstellbereich (II, II', III, IV, V) ausgewählten neuen Steuerungsparameter angesteuert wird, dass sie ein Geräusch mit einer neuen Grundfrequenz (e) emittiert, die zu den weiteren, unverändert angesteuerten geräuschemittierenden Bauteilen (3, 5) im musikalischen Sinne harmonisch ist.

10. Verfahren nach einem der Ansprüche 1 bis 9,
**dadurch gekennzeichnet,**
**dass** bei der Ansteuerung eines Bauteils (3, 5) mit einem neuen Steuerungsparameter ein minimaler Abstand (A) des Steuerungsparameters von den Grenzen des neuen Einstellbereichs gehalten wird.

11. Verfahren nach einem der Ansprüche 1 bis 9,
**dadurch gekennzeichnet,**
**dass** Änderungen von Steuerungsparametern nur zu durch einen Takt Δt vorgegebenen Zeitpunkten stattfinden.

12. Verfahren nach einem der Ansprüche 1 bis 10,
**dadurch gekennzeichnet,**
**dass** Sätze von musikalischen Harmonien in einer Tabelle in Form von Steuerungsparametern gespeichert sind und die jeweils für die Ansteuerung der Bauteile verwendeten Steuerungsparameter aus dieser Tabelle ausgewählt werden.

13. Verfahren nach einem der Ansprüche 1 bis 11,
**dadurch gekennzeichnet,**
**dass** die Grundfrequenzen unterschiedlicher geräuschemittierender Bauteile (3, 5) unterschiedlich gewählt werden.
